# EUROPÄISCHE PATENTANMELDUNG

(11) **EP 0 540 983 A2**
(43) Veröffentlichungstag der Anmeldung: **12.05.1993**
(21) Anmeldenummer: 92118331.5
(22) Anmeldetag: 27.10.1992
(51) Int. Cl.: C23C 16/18, C23C 18/08, C23C 16/48, C23C 16/50, C23C 18/14

(54) **Verfahren zur Abscheidung von Molybdän oder Wolfram enthaltenden Schichten**

(30) Priorität: 05.11.1991 DE 4136321
(71) Anmelder: Solvay Deutschland GmbH, D-30173 Hannover (DE)
(72) Erfinder: Döllein, Günther, Dr., W-3000 Hannover 61 (DE)
(74) Vertreter: Lauer, Dieter, Dr.

(57) **Zusammenfassung**

Beschrieben wird die Herstellung von Molybdän und insbesondere Wolfram enthaltenden Schichten, bevorzugt nach dem CVD-Verfahren. Verwendet werden durch organische Reste substituierte Molybdän- bzw. Wolfram-Carbonyle.

## Beschreibung

Die Erfindung bezieht sich auf ein Verfahren zur Abscheidung einer Molybdän oder Wolfram enthaltenden Schicht auf einem Substrat durch Zersetzung von Koordinationsverbindungen von Molybdän oder Wolfram.

Es ist bekannt, Substrate durch Oberflächenbeschichtung so zu modifizieren, daß ihre Oberfläche bestimmte funktionale Eigenschaften aufweist. Beispielsweise kann man den elektrischen Strom leitende oder halbleitende Schichten, z.B. Leiterbahnen aufbringen. Aus der europäischen Patentanmeldung EP-A 338 206 ist beispielsweise ein Verfahren zum konformen Abscheiden von Wolfram auf Halbleitersubstrate bei der Herstellung von höchstintegrierten Schaltungen bekannt. Als Ausgangsverbindungen werden in jener Anmeldung Wolframverbindungen verwendet. Es handelt sich um W(PF₃)₆, W(PCl₃)₆ oder Komplexe des Typs W(PF₃)₅L, worin L Stickstoff, Aceton, andere Ketone oder Aldehyde, Kohlenmonoxid, Tolan, Acetonitril, Ether oder Tetrahydrofuran bedeutet. Andere einsetzbare Wolframverbindungen betreffen Komplexe mit Tetrahapto- oder Hexahaptoliganden.

Durch Zersetzung dieser Wolfram-Verbindungen, insbesondere nach dem thermischen CVD-Verfahren, Laser- oder Plasma-CVD-Verfahren bei vermindertem Druck und erhöhter Temperatur, können in Isolationsschichten gesetzte Kontaktlöcher mit Wolfram aufgefüllt werden. Dieses Verfahren dient zur. Ausbildung von elektrischen Leiterbahnen bei der Herstellung von höchstintegrierten Halbleiterschaltungen.

Aufgabe der vorliegenden Erfindung ist es, ein Verfahren anzugeben, mit welchem sich in vorteilhafter Weise Molybdän oder Wolfram enthaltende Schichten abscheiden lassen. Diese Aufgabe wird durch das in den Ansprüchen wiedergegebene erfindungsgemäße Verfahren gelöst.

Das erfindungsgemäße Verfahren zur Abscheidung von Molybdän oder Wolfram enthaltenden Schichten durch Zersetzung von Koordinationsverbindungen von Molybdän oder Wolfram ist dadurch gekennzeichnet, daß man eine Verbindung der allgemeinen Formel (I) einsetzt,

M R¹R²(CO)₃ (I)

worin
- M: Molybdän oder Wolfram
- R¹: Cyclopentadienyl; durch 1 bis 5 (C1-C3)-Alkylgruppen substituiertes Cyclopentadienyl; Cycloheptatrienyl, Cyclooctatetraenyl
und
- R²: (C1-C5)-Alkyl; (C2-C5)-Alkenyl; (C2-C5)-Alkinyl; durch Halogen, (C1-C3)-Alkoxy, (C1-C3)-Alkylthio, Phenyl, niedrigalkyl- oder halogensubst. Phenyl, Heteroaryl, Organosilyl substituiertes (C1-C5)-Alkyl, (C2-C5)-Alkenyl oder (C2-C5)-Alkinyl; Aryl; Heteroaryl; durch eine oder mehrere (C1-C3)-Alkylgruppen substituiertes Aryl oder Heteroaryl; (C1-C3)₃Si
bedeuten.

M ist bevorzugt Wolfram. R¹ ist bevorzugt Cyclopentadienyl.
R² kann beispielsweise Methyl, Ethyl, n-Propyl, i-Propyl, sigma-Allyl, Buten-(2)-yl, Propin-(2)-yl, Butin-(2)-yl, 3-Brompropyl, 4-Brombutyl, Methoxymethyl, Methylthiomethyl, Trimethylsilyl, Benzyl, 4-Fluorbenzyl, Pyridyl-(4)-methyl, Thienyl-(2) oder Thienyl-(3) bedeuten.
R² bedeutet bevorzugt (C1-C3)Alkyl,; (C2-C3)-Alkenyl; (C2-C3)-Alkinyl; Phenyl oder durch 1 bis 3 (C1-C3)-Alkyl-gruppen substituiertes Phenyl. Insbesondere bedeutet R² Methyl, Ethyl, n-Propyl, i-Propyl oder Sigma-Allyl, besonders bevorzugt Methyl.

Im Rahmen der vorliegenden Erfindung bedeutet der Begriff "Wolfram oder Molybdän" enthaltende Schichten, daß die Metalle in den Schichten sowohl in metallischer Form als auch in Form von Metallverbindungen oder als Gemisch von solchen enthalten sein können.

Sehr gut geeignete Verbindungen sind z.B. Mo (C₅H₅) (CH₃) (CO)₃, W (C₅H₅) (CH₃) (CO)₃, Mo (C₅H₅) (C₂H₅) (CO)₃, oder W(C₅H₅) (C₂H₅) (CO)₃.

Die vorliegende Erfindung wird nun anhand der bevorzugten Ausführungsform, daß nämlich M Wolfram bedeutet, weiter erläutert.

Zur Abscheidung einer Wolfram enthaltenden Schicht kann der Fachmann die Abscheidung aus der kondensierten Phase oder aus der Gas- bzw. Dampfphase vornehmen. Für den Fachmann ist dabei selbstverständlich, daß er nicht nur eine bestimmte Verbindung der allgemeinen Formel (I), sondern auch Gemische solcher Verbindungen einsetzen kann.

Zur Abscheidung aus der kondensierten Phase bringt der Fachmann die Verbindung der Formel (I) ohne Lösungsmittel oder vorzugsweise in einem Lösungsmittel gelöst auf dem Substrat auf und zersetzt die Verbindung. Als Lösungsmittel können polare oder unpolare, aprotische organische Lösungsmittel, die gewünschtenfalls koordinierende Eigenschaften aufweisen können, verwendet werden. Geeignet sind beispielsweise aliphatische Kohlenwasserstoffe wie Pentan oder Petrolbenzin, aromatische Kohlenwasserstoffe wie Benzol oder Toluol oder Ether wie Tetrahydrofuran.

Um die jeweilige Ausgangsverbindung auf dem Substrat aufzubringen, kann man sich bekannter Methoden bedienen, beispielsweise kann man das Substrat in die Verbindung oder eine entsprechende Lösung eintauchen, man kann die Ausgangsverbindung oder eine entsprechende Lösung auf dem Substrat aufstreichen oder, bevorzugt, die Verbindung oder eine entsprechende Lösung auf das Substrat aufsprühen.

Mittels dieser Ausführungsform des erfindungsgemäßen Verfahrens, nämlich dem Aufbringen der Ausgangsverbindung (bzw. einem entsprechenden Gemisch von Ausgangsverbindungen) aus der kondensierten Phase, gelingt es, auch große Flächen sehr schnell zu beschichten.
Dann erfolgt die Zersetzung der aus der kondensierten Phase auf dem Substrat aufgebrachten Ausgangsverbindung zur AbScheidung einer Wolfram enthaltenden Schicht, gewünschtenfalls unter vermindertem Druck. Zweckmäßig bewirkt man die Zersetzung thermisch oder durch Photolyse, z.B. durch einen bei der entsprechenden Wellenlänge betriebenen Laser oder eine UV-Lampe.

Die Zersetzung kann man plasmainduziert durchführen. Hierzu eignen sich die verschiedenen bekannten Verfahren.
Beispielsweise kann man ein thermisches Plasmaverfahren, z.B. Lichtbogenplasma oder Plasmajet, anwenden. Der Druck liegt dann üblicherweise zwischen 10 Torr und Normaldruck.

Gut geeignet sind insbesondere auch Niederdruckplasmaverfahren, z.B. Gleichstromplasmaverfahren, Glimmentladungsplasmaverfahren und Wechselstromplasmaverfahren, z.B. Niederfrequenz-, Mittelfrequenz-, Hochfrequenzplasmaverfahren und Mikrowellenplasmaverfahren. Man arbeitet üblicherweise bei Drucken unterhalb 10 mbar, beispielsweise zwischen 10⁻² und 1 mbar.

Die plasmainduzierte Zersetzung erfolgt in bekannten Plasmareaktoren. Verwendbar sind beispielsweise Rohr-, Tunnel-, Parallelplatten- und Coronaentladungsreaktoren.

Da die Zersetzung im Plasma gewünschtenfalls bei niedrigen Temperaturen durchgeführt werden kann, ist die Zersetzung im Plasma gut geeignet zur Beschichtung von Substraten mit verhältnismäßig geringerer Thermostabilität, beispielsweise für die Beschichtung von Kunststoffen.

Der Fachmann kann durch Zusatz eines Reaktivgases die Form, in welcher das Wolfram in der Schicht vorliegt, beeinflussen.
Dies, sowie die Möglichkeit der gleichzeitigen Abscheidung anderer Metalle oder der sukzessiven Abscheidung weiterer, insbesondere weiterer Schichten mit anderer Zusammensetzung, wird noch erläutert.

Eine andere Ausführungsform des erfindungsgemäßen Verfahrens betrifft die Zersetzung der Ausgangsverbindung in der Gas- bzw. Dampfphase. In der Dampfphase sind neben der gasförmigen vorliegenden Ausgangsverbindung auch noch Anteile der kondensiert vorliegenden Ausgangsverbindung in feinster Verteilung enthalten. Die Abscheidung aus der Gas- bzw. Dampfphase ermöglicht die Abscheidung besonders gut haftender, gleichmäßiger dünner Schichten.

Der Druck in der Dampfphase bzw. Gasphase kann mehr oder weniger hoch sein. Man kann beispielsweise bei einem Druck arbeiten, der dem Dampfdruck der verwendeten Ausgangsverbindung bei der Arbeitstemperatur entspricht. Der Gesamtdruck kann aber auch höher sein, bis hin zum Normaldruck. Zweckmäßig arbeitet man bei vermindertem Druck, beispielsweise bei 10⁻² bis 10 mbar, vorzugsweise bei 0,1 bis 1 mbar.

Die Zersetzung der Ausgangsverbindung in der Dampfphase oder Gasphase führt man zweckmäßig nach Art eines CVD (Chemical-Vapour-Deposition)-Verfahrens durch. Diese bevorzugte Ausführungsform des erfindungsgemäßen Verfahrens wird im folgenden näher erläutert.

Die prinzipielle Vorgehensweise zur Beschichtung von Substraten unter Anwendung von CVD-Verfahren sowie geeignete Apparaturen dafür sind bekannt. Die EP-A 297 348 (die sich allerdings mit völlig anderen Beschichtungen befaßt als die vorliegende Erfindung, nämlich mit der Abscheidung von Kupfer, Silber oder Gold enthaltenden Schichten) gibt dem Fachmann ausführliche Hinweise, wie ein CVD-Verfahren durchzuführen ist und welche Apparaturen verwendbar sind.

Die Zersetzung aus der Dampfphase bzw. Gasphase wird zweckmäßig in einer druckfesten, evakuierbaren Vorrichtung durchgeführt. In diese Vorrichtung wird das zu beschichtende Substrat eingebracht. Bei vermindertem Druck wird eine Atmosphäre erzeugt, welche die Ausgangsverbindung enthält. Neben der dampf- bzw. gasförmigen Ausgangsverbindung kann gewünschtenfalls Inertgas oder Reaktivgas im Gasraum der Vorrichtung vorhanden sein.

In einer Variante wird die Ausgangsverbindung zusammen mit dem zu beschichtenden Substrat in die Vorrichtung eingebracht.

In einer alternativen, bevorzugten Variante wird zunächst nur das Substrat in die druckfeste Vorrichtung eingebracht und die bereits gas- bzw. dampfförmig vorliegende Ausgangsverbindung über eine besondere Leitung kontinuierlich oder diskontinuierlich in die Vorrichtung eingebracht. Auch hier kann ein Trägergas angewendet werden.

Die Überführung der Ausgangsverbindung in die Dampf- bzw. Gasphase kann man durch Erwärmen und gewünschtenfalls durch Zusatz eines Trägergases unterstützen.

Die Zersetzung erfolgt nach bekannten Methoden thermisch, plasmainduziert und/oder photolytisch.

Die thermische Zersetzung aus der Dampfphase führt man in üblicher Weise so durch, daß die Wände der Vorrichtung kalt gehalten werden und das Substrat auf eine Temperatur erhitzt wird, bei welcher sich die gewünschte Übergangsmetall enthaltende Schicht auf dem Substrat abscheidet.

Der Fachmann kann durch einfache orientierende Versuche für die jeweils eingesetzte Verbindung die notwendige Mindesttemperatur leicht bestimmen. Für Wolframverbindungen liegt sie z.b. oberhalb von etwa 80 °C.

Die Beheizung der Substrate kann in üblicherweise erfolgen, beispielsweise durch Widerstandsheizung, Induktionsheizung, elektrische Heizeinrichtung wie Heizwendeln oder ähnlichem. Die Aufheizung der Substrate kann auch durch Strahlungsenergie induziert werden. Hierfür eignet sich insbesondere Laserstrahlungsenergie. Beispielsweise kann man Laser verwenden, die im Bereich des sichtbaren Lichtes, im UV-Bereich oder im IR-Bereich arbeiten. Laser besitzen den Vorteil, daß man sie mehr oder weniger fokussieren kann und daher gezielt bestimmte, begrenzte Bereiche oder Punkte des Substrats erhitzen kann.

Da das thermische CVD-Verfahren üblicherweise bei Unterdruck, beispielsweise bei einem Druck von 10⁻² bis 10 mbar, vorzugsweise 0,1 bis 1 mbar, durchgeführt wird, ist es für den Fachmann selbstverständlich, druckfeste Apparaturen vorzusehen, wie sie in der Vakuumtechnik verwendet werden. Die Apparaturen weisen zweckmäßigerweise beheizbare Gasleitungen für die verwendete Koordinationsverbindung oder das Inertgas, absperrbare Öffnungen für Gaseinlaß und Gasauslaß auf, ggf. Öffnungen zur Zuführung eines Trägers oder Reaktivgases, Temperaturmeßeinrichtungen, gewünschtenfalls eine Öffnung für die Zuführung der verwendeten Koordinationsverbindung, eine Einrichtung für die Aufheizung des Substrats, eine zur Erzeugung des gewünschten Unterdruckes geeignete Pumpe etc. Für den Fall der Durchführung eines durch Strahlungsenergie induzierten CVD-Verfahrens muß auch noch eine Strahlungsquelle vorhanden sein, die Strahlung im Bereich des sichtbaren Lichtes, des Infrarot- oder Ultraviolett-Bereiches abgibt.

Besonders geeignet sind entsprechende Laserstrahlungsenergiequellen. Mittels der Strahlungsenergie kann das Substrat aufgeheizt werden.

Wie schon gesagt, kann die Zersetzung auch photolytisch bewirkt werden, indem man einen mit geeigneter Wellenlänge arbeitenden Laser oder eine UV-Lampe verwendet.

Die plasmainduzierte Zersetzung führt man in einer schon vorstehend beschriebenen Apparatur durch.

Ohne daß hier eine Erklärung für die Bildung einer Schicht durch Zersetzung der Ausgangsverbindungen gegeben werden soll, wird angenommen, daß Gase bzw. Dämpfe der Verbindung auf das erhitzte Substrat gelangen und dort unter Bildung der Schicht zersetzt werden. Die Dicke der Schicht ist im wesentlichen abhängig von der Zeitdauer, während welcher die Abscheidung durchgeführt wird, vom Partialdruck und von der Abscheidungstemperatur. Es lassen sich mehr oder weniger dünne Schichten erzeugen, beispielsweise Schichten mit einer Dicke von bis zu 20 Mikrometer, beispielsweise zwischen 100 Angström und 20 Mikrometer. Je nach gewünschter Schichtdicke kann der Fachmann durch orientierende Versuche die zur Erzeugung einer Wolfram enthaltenden Schicht bestimmter Dicke notwendige Zeitdauer und Abscheidungstemperatur bestimmen.

Der das Substrat umgebende Raum enthält die gas- bzw. dampfförmig vorliegende Ausgangsverbindung. Es wurde bereits weiter oben erwähnt, daß weiterhin ein Inertgas oder ein Reaktivgas in der Gas- bzw. Dampfatmosphäre enthalten sein kann. Abhängig von der Art der Durchführung werden ganz unterschiedliche Wolfram enthaltende Schichten abgeschieden.

Zersetzt man die Ausgangsverbindung in reduzierender Atmosphäre, vorzugsweise in Wasserstoff enthaltender Atmosphäre, so scheiden sich bei thermischer Zersetzung, insbesondere bei der Durchführung als CVD-Verfahren, Schichten ab, die Wolfram bzw. Molybdän im wesentlichen in metallischer Form enthalten.

In einer anderen Ausführungform führt man die Zersetzung in einer Reaktivgasatmosphäre durch. Eine solche reaktive Gasatmosphäre kann natürlich zusätzlich Inertgas enthalten, beispielsweise Edelgase wie Argon.

In einer Variante führt man die Zersetzung insbesondere nach Art eines thermischen oder plasmainduzierten CVD-Verfahrens durch.

Durch Zersetzung der Ausgangsverbindung in einer Reaktivgasatmosphäre, die die Carbidbildung fördert, beispielsweise einer Atmosphäre, die kohlenstoffhaltige Gaszusätze, z.B. Kohlenwasserstoffe, insbesondere kurzkettige Alkane wie Methan, Ethan oder Propan enthält, oder einer Gasatmosphäre, die die Carbonitridbildung fördert, z.B. einer Atmosphäre, die kohlenstoffhaltige Gaszusätze, z.B. Kohlenwasserstoffe, insbesondere kurzkettige Alkane wie Methan, Ethan oder Propan und NH₃, Hydrazin, Stickstoffwasserstoffsäure, N₂, oder N-haltige Gaszusätze wie Amine enthält, bilden sich Schichten, die das Metall im wesentlichen in Form des Carbids oder Carbonitrids, MCₓN_{y}, enthalten.

In einer anderen Variante führt man die Zersetzung ebenfalls insbesondere nach Art eines thermischen oder plasmainduzierten CVD-Verfahrens durch und zersetzt die Wolfram enthaltende Ausgangsverbindung in einer hydrolysierenden und/oder oxidierenden Reaktivgasatmosphäre. Zweckmäßig enthält diese Reaktivgasatmosphäre Wasser und/oder N₂O, Sauerstoff oder Ozon. Bei der Zersetzung bilden sich Schichten, die das Übergangsmetall im wesentlichen in Form des Oxids enthalten.

Im erfindungsgemäßen Verfahren kann man im Prinzip beliebige Substrate beschichten, auf denen eine Beschichtung wünschenswert ist. Beispielsweise kann man anorganische Materialien, wie Metalle oder Metallegierungen, z.B. Stahl, Silicium, Halbleiter, Isolatoren, z.B. SiO₂, Keramik oder organische Polymere, z.B. Polyphenylensulfid, Polyamide oder Polyimide als Substrate verwenden.

Die Abscheidung von Schichten, die Molybdän oder Wolfram im wesentlichen in metallischer Form enthalten, ermöglicht beispielsweise unter Abdeckung bestimmter nicht zu beschichtender Bereiche nach an sich bekannten Strukturierungsverfahren die Erzeugung für den elektrischen Strom leitfähiger Leiterbahnen auf nichtleitenden Substraten, beispielsweise auf Keramik oder organischen Polymeren.
Auf metallischen Substraten beispielsweise beobachtet man unter bestimmten Voraussetzungen an sich bekannte Diffusionsphänomene. Metallisches Wolfram oder Molybdän, aufgebracht auf Siliciumsubstraten, diffundieren bei Aufheizung der Substrate auf hohe Temperaturen, beispielsweise 700 °C, in diese Siliciumsubstrate ein und bilden Schichten, die mehr oder weniger Wolfram bzw. Molybdän enthalten und im Grenzfall Wolfram- oder Molybdänisilicid darstellen. Solche Silicide sind Oxidationsschutzschichten in der Elektronik.

Wolframoxid enthaltende Schichten können beispielsweise als dekorative Schichten Anwendung finden.

Carbid oder Carbonitrid enthaltende Schichten von Wolfram oder Molybdän sind z.B. Hartstoffschichten.

Das erfindungsgemäße Verfahren bietet dem Fachmann aber noch weitere Möglichkeiten. Es eignet sich beispielsweise auch zur Abscheidung von Schichten, welche neben dem Molybdän oder Wolfram ein oder mehrere andere Metalle enthalten. Diese Ausführungsform des erfindungsgemäßen Verfahrens ist dadurch gekennzeichnet, daß man zur Abscheidung von Molybdän oder Wolfram enthaltenden Schichten, welche weiterhin ein oder mehrere andere Metalle enthalten, eine oder mehrere Verbindungen anderer Metalle und eine Verbindung der allgemeinen Formel (I) gleichzeitig zersetzt. Es bilden sich dann Schichten, die Molybdän oder Wolfram und ein oder mehrere andere Metalle in homogener Mischung enthalten. Auch bei dieser Ausführungsform kann man in inerter oder Reaktivgasatmosphäre arbeiten. Man kann natürlich auch zwei Verbindungen der allgemeinen Formel (I) einsetzen, in welchen M unterschiedliche Bedeutung besitzt.

Durch gleichzeitige Zersetzung beispielsweise von W(C₅H₅) (CH₃) (CO)₃ und Mo(C₅H₅) (CH₃) (CO)₃ in Reaktivgasatmosphäre mit Zusatz von Alkanen, insbesondere kurzkettigen Alkanen, und N-haltigen Zusätzen lassen sich Wolfram-Molybdän-Carbonitrid enthaltende Hartstoffschichten erzeugen.

Weiterhin kann der Fachmann mehrere unterschiedliche Schichten sukzessive nacheinander auf Substraten aufbringen, wobei mindestens eine Schicht gemäß dem erfindungsgemäßen Verfahren erzeugt wird.

Beispielsweise kann man auf einem Substrat nach bekannten Verfahren zunächst eine Titannitrid oder Zirkoniumnitrid enthaltende Schicht abscheiden, welche als Diffusionssperre wirkt und zudem die Haftung weiterer abzuscheidender Schichten verbessert. Dann kann man nach dem erfindungsgemäßen Verfahren durch geeignete Abdeckung bestimmter nicht zu beschichtender Bereiche nach an sich bekannten Strukturierungsverfahren Leiterbahnen erzeugen, indem man metallisches Wolfram enthaltende Schichten gemäß dem erfindungsgemäßen Verfahren abscheidet. Gewünschtenfalls kann man dann erneut eine Titannitrid enthaltende Schicht als Schutzschicht abscheiden.

Die im erfindungsgemäßen Verfahren einzusetzenden Verbindungen der allgemeinen Formel (I) und ihre Herstellung ist bekannt. Die Herstellung wird beispielsweise in den Lehrbüchern "Handbuch der präparativen anorganischen Chemie, (herausgegeben von G. Blauer, 3 Aufl., 1981)", 3. Bd., Seiten 1947 und 1948 in Verbindung mit den Seiten 1914 und 1915, sowie "Methoden der organischen Chemie (Houben-Weyl)", 4. Auflage (1975), Band XIII/7, Seiten 493 bis 498 beschrieben.

Zunächst stellt man das Natriumsalz von Cyclopentadien oder des gewünschten substituierten Cyclopentadiens her (Cyclopentadienyl-Natrium ist ein Handelsprodukt), beispielsweise durch Umsetzung von Cyclopentadien oder eines substituierten Cyclopentadiens mit Natrium. Zur Lösung des entsprechenden Natriumsalzes gibt man W(CO)₆ bzw. Mo(CO)₆ im Molverhältnis 7:5 und hält die Reaktionsmischung 12 Stunden lang bei Rückflußtemperatur. Das Lösungsmittel wird dann im Vakuum entfernt und etwaig vorliegendes unumgesetztes Hexacarbonyl bei 60 °C aus dem Rohprodukt heraussublimiert. Es verbleibt das Natriumsalz des Tricarbonyl-(R¹)-metallats, bei Umsetzung von Cyclopentadienyl-Natrium mit Wolfram-Hexacarbonyl oder Molybdänhexacarbonyl also das Natriumsalz des (Tricarbonyl-Cyclopentadienyl)-metallats. Das Rohprodukt wird dann mit R²Cl, R²Br oder R²I zur gewünschten Verbindung der Formel (I) weiter umgesetzt. Die Isolierung und Reinigung erfolgt in üblicher Weise durch Abdampfen des Lösungsmittels, Sublimieren, Umkristallisieren.
Es gibt noch weitere Verfahren, die zu Verbindungen der allgemeinen Formel (I) führen. So kann man Tricarbonyl-(R¹)-Hydridometallate mit Diazoverbindungen umsetzen. Die Methylverbindung entsteht beispielsweise aus der Reaktion des entsprechenden Hydridowolframats mit Diazomethan.

Tricarbonyl- (Cyclopentadienyl)-Isopropyl-Wolfram entsteht beispielsweise aus Sigma-Allyl-Tricarbonyl(Cyclopentadienyl)-Wolfram durch Protonieren mit HCl und Hydrieren des erhaltenen Reaktionsproduktes mit Natrium-Borhydrid.

Methyl-Tricarbonyl-(Pentamethylcyclopentadienyl)Wolfram beispielsweise wird durch die Umsetzung von Acetyl-Pentamethyl-cyclopentadien und (CH₃CN)₃ W(CO)₃ in Methyl-Cyclohexan als Lösungsmittel hergestellt: (CH₃CN)₃ W (CO₃) seinerseits ist durch UV-Bestrahlung von W(CO₆) in Acetonitril erhältlich. Man hält die Reaktionsmischung 48 Stunden bei Rückflußtemperatur, entfernt das Lösungsmittel und extrahiert den Rückstand mit Hexan. Die vereinigten Hexan-Extrakte werden an einer mit Fluorisil gefüllten Kolonne chromatographiert. Die erste gelbe Bande wird mit Hexan eluiert.

Das gewünschte Produkt wird durch Abtrennung des Lösungsmittels isoliert.

Das erfindungsgemäße Verfahren weist den Vorteil auf, daß die dabei verwendeten Verbindungen der Formel (I) leicht zugänglich und aufgrund ihrer Stabilität an der Luft auch sehr gut handhabbar sind.

Die folgenden Beispiele sollen das erfindungsgemäße Verfahren weiter erläutern, ohne es in seinem Umfang einzuschränken.

### Beispiel 1:

Herstellung von Methyl-Tricarbonyl-(Cyclopentadienyl)-Wolfram.
Die Herstellung erfolgte nach dem Verfahren, das im "Handbuch der präparativen anorganischen Chemie", herausgegeben von G. Brauer, 3.Aufl., 1981, 3.Bd., Seite 1914 und 1915 beschrieben wird. Die Herstellung des dabei benötigten Natrium- (Tricarbonyl-) (Cyclopentadienyl) -Wolframats erfolgte nach der Beschreibung auf den Seiten 1947 und 1948 im selben Band.
Die Herstellung wurde unter Inertgas durchgeführt.
In einem 500-ml-Einhalskolben mit aufgesetztem Luftkühler wurden 19 g W(CO₆) (54 mmol) und 6,7 g (75,6 mmol) Cyclopentadienyl-Natrium sowie 100 ml N,N-Dimethylformamid (DHF) eingegeben. Die Reaktionsmischung wurde auf 130 °C erwärmt und 2 Stunden bei dieser Temperatur gehalten. Es bildete sich eine Lösung des Natriumsalzes von Tricarbonyl-(Cyclopentadienyl)-Wolframat. Die Lösung wurde bei 50 bis 80 °C im Hochvakuum eingeengt, der verbleibende Rückstand wird in 50 ml Tetrahydrofuran aufgelöst und 16 ml Methyljodid bei 0 °C unter Rühren hinzugefügt. Natriumjodid fiel aus, und die gewünschte Wolframverbindung Tricarbonyl-Methyl-(Cyclopentadienyl)-Wolfram bildete sich. Die Umsetzung wurde durch dreistündiges Erwärmen auf 40 °C vervollständigt. Flüchtige Bestandteile der Reaktionsmischung wurden im Wasserstrahlvakuum bei 30 bis 40 °C abgetrennt, der Rückstand bei Raumtemperatur im Hochvakuum getrocknet und die gewünschte Wolframverbindung durch Sublimation im Hochvakuum bei einer Temperatur von 60 bis 65 °C isoliert. Die Ausbeute betrug 15,2 g.
Die Verbindung schmolz bei 144 °C unter Zersetzung.

### Beispiel 2:

Herstellung von Methyl-Tricarbonyl-(Cyclopentadienyl)-Molybdän.
Die Herstellung erfolgt analog der in Beispiel 1 beschriebenen Herstellung der entsprechenden Wolfram-Verbindung. Es wurden 14,5 g (55 mmol) Mo(CO)₆ und 6,9 g (78 mmol) Cyclopentadienyl-Natrium eingesetzt.
Die Isolierung des gewünschten Produktes erfolgte durch Hochvakuumsublimation bei 50 bis 55 °C.
Die Molybänverbindung schmolz bei etwa 124 °C unter Zersetzung.

### Beispiel 3:

Anwendung der gemäß Beispiel 1 hergestellten Wolfram-Verbindung zur Abscheidung Wolfram enthaltenden Schichten.
Ein Quarzglasrohr war konzentrisch in einem 2-Zonenröhrenofen eingebracht. Die eine Seite des Quarzrohres war absperrbar mit einer Gaszuleitung verbunden, die andere Seite mit einer Vakuumpumpe. Die zu verdampfende, gemäß Beispiel 1 hergestellte Wolframverbindung wurde in einem Porzellanschiffchen in das Glasrohr der 1. Heizzone des Ofens positioniert und die Vorrichtung 10 Minuten lang mit Argon gespült. Als Substrat diente ein Glasträger innerhalb der 2. Heizzone. Der Glasträger wurde auf 400 °C erhitzt, der Druck auf 10⁻² Torr eingestellt. Die Ausgangsverbindung in der 1. Heizzone wurde auf 80 °C erwärmt. Der sich dabei bildende Dampf der Ausgangsverbindung strömte über den Glasträger und zersetzte sich unter Abscheidung einer überwiegend Wolfram enthaltenden, metallisch glänzenden Schicht. Ein Trägergas wurde nicht verwendet.

### Beispiel 4:

Abscheidung einer Wolfram enthaltenden Schicht mit Wasserstoff als Trägergas.
Beispiel 3 wurde wiederholt. Mit 20 sccm Wasserstoff als Trägergas konnte der Wolframgehalt der abgeschiedenen Schicht signifikant erhöht werden.

## Patentansprüche

1. Verfahren zur Abscheidung von Molybdän oder Wolfram enthaltenden Schichten unter Zersetzung von Koordinationsverbindungen von Molybdän oder Wolfram, dadurch gekennzeichnet, daß man eine Verbindung der allgemeinen Formel (I) einsetzt
M R¹R²(CO)₃ (I)
worin
M Molybdän oder Wolfram
R¹ Cyclopentadienyl; durch 1 bis 5 (C1-C3)-Alkylgruppen substituiertes Cyclopentadienyl; Cycloheptatrienyl, Cyclooctatetraenyl
und
R³ (C1-C5)-Alkyl; (C2-C5)-Alkenyl; (C2-C5)-Alkinyl; durch Halogen, (C1-C3)-Alkoxy, (C1-C3)-Alkylthio, Phenyl, subst. Phenyl, Heteroaryl, Organosilyl substituiertes (C1-C5) -Alkyl, (C2-C5) - Alkenyl oder (C2-C5) -Alkinyl; Aryl; Heteroaryl; durch eine oder mehrere (C1-3) -Alkylgruppen substituiertes Aryl oder Heteroaryl; (C1-C3)₃Si
bedeuten.

2. Verfahren nach Anspruch 1, dadurch gekennzeichnet, daß M Wolfram bedeutet.

3. Verfahren nach Anspruch 1 oder 2, dadurch gekennzeichnet, daß R¹ Cyclopentadienyl bedeutet.

4. Verfahren nach einem der vorhergehenden Ansprüche, dadurch gekennzeichnet, daß R² (C1-C3)-Alkyl; (C2-C3)-Alkenyl; (C2-C3)-Alkinyl; Phenyl; durch 1 bis 3 (C1-C3)-Alkyl-gruppen substituiertes Phenyl bedeutet.

5. Verfahren nach Anspruch 4, dadurch gekennzeichnet, daß R² Methyl, Ethyl, n-Propyl, i-Propyl oder Allyl, vorzugsweise Methyl bedeutet.

6. Verfahren nach einem der Ansprüche 1 bis 5, dadurch gekennzeichnet, daß man die Verbindung der allgemeinen Formel (I) in der Flüssigphase zersetzt.

7. Verfahren nach Anspruch 6, dadurch gekennzeichnet, daß man die Verbindung der allgemeinen Formel (I) auf das Substrat aufbringt, vorzugsweise aufsprüht, und zersetzt.

8. Verfahren nach einem der Ansprüche 1 bis 5, dadurch gekennzeichnet, daß man die Verbindung der allgemeinen Formel (I) in der Gas- oder Dampfphase zersetzt.

9. Verfahren nach Anspruch 8, dadurch gekennzeichnet, daß man die Verbindung der allgemeinen Formel (I) unter vermindertem Druck, gewünschtenfalls unter Anwendung eines Trägergases, in die Gas- oder Dampfphase überführt und bei vermindertem Druck zersetzt.

10. Verfahren nach einem der vorhergehenden Ansprüche, dadurch gekennzeichnet, daß man die Zersetzung thermisch bewirkt.

11. Verfahren nach einem der vorhergehenden Ansprüche, dadurch gekennzeichnet, daß man die Zersetzung mittels Strahlungsenergie, insbesondere Laserstrahlungsenergie bewirkt.

12. Verfahren nach einem der Ansprüche 1 bis 9, gekennzeichnet durch plasmainduzierte Zersetzung.

13. Verfahren nach einem der vorhergehenden Ansprüche, dadurch gekennzeichnet, daß man zur Abscheidung von Schichten, die Molybdän oder Wolfram im wesentlichen in metallischer Form enthalten, die Zersetzung in einer reduzierend wirkenden Atmosphäre, insbesondere Wasserstoff enthaltenden Gasatmosphäre durchführt.

14. Verfahren nach einem der Ansprüche 1 bis 12, dadurch gekennzeichnet, daß man zur Abscheidung von Schichten, die Molybdän oder Wolfram im wesentlichen in Form der Carbide, Carbonnitride oder Oxide enthalten, die Zersetzung in Anwesenheit einer reaktiven Atmosphäre, vorzugsweise einer oxidierenden, hydrolysierenden oder carbonisierenden bzw. die Carbidbildung oder Carbonitridbildung fördernden Gasatmosphäre durchführt.

15. Verfahren nach einem der vorhergehenden Ansprüche, dadurch gekennzeichnet, daß man zur Abscheidung von Molybdän oder Wolfram enthaltenden Schichten, welche weiterhin ein anderes Metall oder mehrere andere Metalle enthalten, eine oder mehrere Verbindungen solcher anderen Metalle sowie eine Verbindungen der allgemeinen Formel (I) gleichzeitig zersetzt.

16. Verfahren nach einem der vorhergehenden Ansprüche, dadurch gekennzeichnet, daß man mehrere unterschiedliche Schichten nacheinander abscheidet.
